# EUROPEAN PATENT SPECIFICATION

(11) **EP 3 769 348 B1**
(45) Date of publication and mention of the grant of the patent: **12.01.2022**
(21) Application number: 19710709.7
(22) Date of filing: 20.03.2019
(51) Int. Cl.: H01L 41/04

(54) **ACTUATOR DEVICE AND ACTUATION METHOD**
AKTUATORVORRICHTUNG UND BETÄTIGUNGSVERFAHREN
ACTIONNEUR, DISPOSITIF ET PROCÉDÉ D'ACTIONNEMENT

(30) Priority: 21.03.2018 EP 18163191
(43) Date of publication of application: 27.01.2021
(73) Proprietor: Koninklijke Philips N.V., 5656 AG Eindhoven (NL)
(72) Inventor: HILGERS, Achim, Rudolf, 5656 AE Eindhoven (NL)
(74) Representative: Philips Intellectual Property & Standards
(86) International application number: PCT/EP2019/056901
(87) International publication number: WO 2019/180055

(56) References cited:
- WO-A1-2016/193131
- WO-A1-2018/001839

## Description

### FIELD OF THE INVENTION

This invention relates to an actuator device and method, and in particular an electroactive polymer actuator device and method.

### BACKGROUND OF THE INVENTION

WO 2016/193131 discloses an actuator device comprises an electroactive polymer and a controller for delivering a drive signal to the electroactive polymer to make it deform. The controller is adapted to generate a signal which comprises an AC component for introducing a vibration of the electroactive polymer. This vibration is used to reduce friction between the electroactive polymer and an adjacent component. The AC component may be superposed on a low frequency AC or DC drive level. The device can be reset by applying only a small AC signal to overcome the friction and bring the device back to its original state.

WO 2018/001839 discloses an electroactive polymer actuator comprises an electroactive polymer structure and a driver for providing an actuation drive signal. In one aspect a first drive level is used to charge the electroactive polymer structure from a non-actuated state to an actuated state. When or after the electroactive polymer structure reaches the actuated state, a lower second drive level is used to hold the electroactive polymer structure at the actuated state. This temporary overdrive scheme improves the speed response without damaging the electroactive polymer structure.

Electroactive materials (EAMs) are a class of materials within the field of electrically responsive materials. When implemented in an actuation device, subjecting an EAM to an electrical drive signal can make it change in size and/or shape. This effect can be used for actuation and sensing purposes. There exist inorganic and organic EAMs. One particular kind of organic EAM is that of electroactive polymers (EAPs).

Electroactive polymers (EAPs) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications. An EAP device can be used in any application in which a small amount of movement of a component or feature is desired, based on electric actuation. Similarly, the technology can be used for sensing small movements.

In general, it is desirable to obtain a single step actuation response for a single step drive voltage provided to an actuator. In practice however, EAP actuators respond too slowly to applied step voltages to achieve this. Instead, an initial rapid actuation response occurs, after which a slow drifting increase in actuation follows due to slow relaxation effects internally in the EAP. This undermines rapidity of response and also positional stability of the actuator: precise positional placement of an actuator cannot be achieved on short time scales, due to the slow upward drift toward a final deformation position.

Accelerated response of EAP actuators to applied drive signals is desired, such that actuation response more closely resembles a step-change. One possible solution would be to drive the EAP for a certain time at a higher voltage amplitude than the normal operation voltage and thus achieve accelerated response. This is generally referred to as overdriving. In a more particular example, an instantaneous overdriving pulse voltage might be applied to the EAP to take advantage of the fast initial response phase of a typical EAP, followed by relaxing this overdriving voltage over different timescales to compensate for the later delayed response phase of the EAP.

However, this solution requires reasonably high overdrive voltage amplitudes, which limits their applicability at high driving amplitudes and may in certain cases damage or destroy the responsive characteristics of the EAP material.

Therefore, there is a desire to have accelerated response of EAP actuators to applied drive signals which can avoid damaging effects of very high overdrive voltages.

### SUMMARY OF THE INVENTION

It is an object of the invention to at least partly fulfill the above desire. The invention is defined by the independent claims. The dependent claims define advantageous embodiments.

According to an aspect of the invention, there is provided an actuator device comprising an actuator member that exhibits known levels of deformation (first and second) in response to a given set of actuation signals (first and second). The second level of deformation is higher than the first level of deformation. Usually, but not necessarily, this means that the second actuation signal is stronger than the first signal. The member is also constructed such that it exhibits a reduction in level of deformation from the second level to the first level in response to an electrical signal including an alternating signal (AC signal). The controller is adapted to provide the second actuation signal and the AC signal at least partly superposed in order to arrive at the first actuation level. Thus, in other words, the controller is configured to control the actuator member to deform to a given level by supplying an actuation signal of a level greater than necessary to achieve the given deformation level and supplying an AC signal with a level sufficient to reduce the deformation level to said given deformation level. The applied actuation and AC signal levels being derived based on the known set of actuator member deformation responses.

The invention is based on the realization that the negative (relaxation) actuation response of an EAP actuator to application of AC signals is significantly faster than the typical (delayed) positive actuation response to drive signals, and the insight that AC signals might therefore be used to help shape a desired rapid actuation response of an actuator. The use of the AC signal allows reduction of the overdrive signal that would otherwise be necessary to achieve a same overall deformation response.

Furthermore, it is thought useful to have low-level overdriving of the actuator member in order to achieve accelerated actuation response, in combination with AC actuation, in order to curtail the over-deflection which this low-level overdriving would otherwise cause.

This combination of overdriving and AC induced relaxation driving may result in a fast overall actuation to a particular desired actuation level. Furthermore, it avoids the need (required in other possible solutions for instance) of rapidly reducing the drive voltage after the initial overdrive, which rapid change can lead to damaging effects on the EAP and reduction in lifetime as well as to undesired mechanical vibrations. In addition, the combination driving allows for use of lower overdrive voltages than other methods would require, because the overdrive signal can be applied over a longer period due to the fast-acting compensating effect of the AC signal. This in turn means any over-deflection can be curtailed faster, so the overdrive signal does not need to be removed so soon. This avoids damaging effects of applying high voltages, which can lead to destruction of the device through electrical breakdown.

Since the AC-signal response is fast, by applying the signals either synchronously or temporally close together, a step-like actuation response can be achieved, thereby significantly improving actuation response speed. It is also possible to have a small delay between the actuation signal and AC signal while still achieving step-like actuation response.

The AC signal induces a one-way reduction in the actuation level from the second to first level. In particular, the AC signal does not simply cause an oscillating effect in the actuation state in which actuation moves back and forth from lower to higher actuation states. Instead, a stable, non-reversing reduction from the second to first actuation level is instituted. This may result from the mechanical effects of heating, as explained above, and in more detail below.

By level of deformation level generally meant an extent of deformation or deflection of the actuator, or the exhibited actuation displacement for instance. Typically, an actuator may be constructed such that the member is controllable through varying the drive signals (e.g. voltage) to progress through a range of actuation positions. This range of positions may describe or follow a spatial path or axis allowing definition of a notional positive and negative actuation direction.

The 'known level of deformation' or 'first level of deformation' or 'second level of deformation' can be defined to be a particular deformation achieved after a particular duration of providing an associated actuation signal to the actuator member. This particular duration may be a time necessary to cause full relaxation of the EAP such that the actuation achieved has become substantially constant during the application of the actuation signal, but this need not be so. As long as the duration of application of the actuation signals to the actuator member for finding the accompanied defined levels of deformation are the same, the levels of deformation can be used to compare.

The actuation signal may be a DC signal or an AC signal. These may have any waveform shape, block pulse, triangle, or other. In all cases, the actuation signal is of lower frequency than the AC signal.

The actuation signal may have a signal level which may for example refer to an actuation signal voltage level or actuation signal current level. This may be a constant DC voltage or current or alternatively an AC voltage amplitude or current amplitude for instance.

The AC signal level may refer to an AC voltage amplitude or current amplitude, or may refer to an AC frequency in other examples. A level of resulting heating in the EAP may be positively correlated with both AC voltage amplitude and AC frequency.

The actuator member may exhibit a deformation response in a first direction in response to the actuation signal, and a deformation response in the opposite actuation direction in response to the AC signal. The AC signal deflection can be regarded a relaxation response, i.e. from a more actuated state to a less actuated state. The deformation response may manifest in a deflection of the actuator in said first and opposite directions.

The terms 'known levels of deformation' and 'known reduction in level of deformation' might be replaced therefore with the terms 'known levels of deflection in a first direction' and 'known levels of deflection in a second, opposing, direction'. The invention thus defined remains compatible with all embodiments and examples outlined in this disclosure.

The AC signal may be a heating signal for inducing heating of the actuator member. This will be explained in more detail in the next section.

The controller may further be adapted to taper the supplied actuation signal and AC signal after their application such as to maintain the actuator member at said given deformation level. After applying the actuation signal, the slow, delayed part of the actuation response continues. Without further control steps, this would lead to a positive drifting of the actuator position away from the given (desired) actuation level. To prevent this, one or both of the applied AC and actuation signals may be tapered (i.e. reduced).

The aim of the tapering is to gradually reduce the signals once the given (desired) actuation level is reached. The deformation will slowly increase with time due to delayed response of EAP to the supplied signal. Tapering may hence be performed so as to avoid drift away from the reached deformation level.

Tapering may comprise progressively (gradually) reducing the respective signal levels.

The rate of tapering of one or both of the actuation signal and AC signal may in examples be determined based on a known actuation level increase as a function of time for the initially supplied actuation signal. In this way, the rate of tapering may be made to match or follow the rate of positive drifting of the actuator position after the given (desired) actuation level has been reached. Hence, drift can be exactly compensated.

The tapering may comprise reducing the actuation signal to the level required for achieving the given actuation level, based on the known set of actuator member deformation responses, and reducing the AC signal level to zero. Hence, the tapering reduces the actuation signal to the signal level known to correspond to a final deformation level (after delay) which matches that which is desired and which has (in theory) been initially reached through combined overdrive and AC signal. Hence the overdrive part of the actuation signal (the extra part above what is required to achieve the desired actuation level) is progressively removed, while the AC signal can be reduced to zero.

Hence, the slow positive drift due to delayed actuation response may be gradually accommodated by tapering away the overdrive part of the actuation signal, along with the AC signal.

The tapering of the actuation and AC signals may be performed after a given time delay, or upon determining that said given deformation level has been reached. The determining may be sensed by the actuator member itself, e.g. based on a sensed capacitance of the actuator member, which may typically be correlated with actuation extent.

Tapering of the actuation signal and AC signal may be performed synchronously and at a corresponding rate. By corresponding rate may be meant a rate exhibiting the same proportional decrease in signal level per unit time.

In examples, the actuator member exhibits a known variation in deformation level as a function of actuation signal strength, and exhibits a known reduction in deformation level as a function of AC signal level. In these examples, a continuous function of actuation level vs signal level is known for the actuator member over a particular range, i.e. there is a known continuous response function for varying signal level.

In alternate examples, simply a discrete set of actuation level responses for a respective given set of actuation signal and AC signal levels may be known (e.g. stored in a memory). In these cases, a required actuation signal level for a particular actuation level which lies between or outside known points may be derived through interpolation or extrapolation for instance.

The given set of AC signal levels may comprise a given set of AC signal amplitudes and/or a given set of AC signal frequencies. Accordingly, there may be a known set of actuation responses for a given set of AC signal voltages or current amplitudes or a given set of AC signal frequencies, or both.

The controller may be adapted to supply an actuation signal of a level no greater than 12% higher than necessary to realize the given deformation level and preferably between 8% and 12% higher than necessary. A level less than 12% greater than necessary has been found to reliably avoid damage to the EAP actuator member through excessive overdriving.

In advantageous examples, the controller may be adapted to supply an actuation signal of a level no greater than 10% higher than necessary to realize the given deformation level. This has been found to most reliably avoid damage to the actuator member through overdriving.

The actuation signal and AC signal may be supplied to the actuator member synchronously. This may lead to the fastest actuation response which most closely resembles a single step response. However, a few second delay between applying the actuation signal and AC signal may in certain examples not result in perceptible decrease in actuation response speed or sharpness of perceived step response.

By synchronously is meant that supply of the actuation signal and AC signal is commenced at least partly, but in some cases preferably completely, at the same time.

In further examples, the actuation signal and AC signal may be supplied to the actuator member asynchronously, and optionally wherein supply of the AC signal is begun in advance of supply of the actuation signal. Beginning supply of the AC signal in advance results in a "feed forward approach", wherein AC actuation and hence heating is pre-applied to the actuator member, generating an initial negative offset in actuation position. Applying the overdriven actuation signal overcomes the negative offset, leading to exactly reaching the desired actuation level upon first applying the actuation signal. This approach may even lead to greater acceleration since there is no delay at all in the AC signal response (as the signal is already applied before the actuation is begun).

Tapering of one or both signals may be performed as outlined in any of the examples above also in combination with this set of 'feed forward' examples.

In alternative examples however, the actuation signal may be supplied in advance of the AC signal without significantly affecting operation of the device. In particular, if the delay between supply of the actuation signal and supply of the AC signal is kept to less than approximately 5 seconds or more preferably less than approximately 2 seconds, there is no measurable delay in curtailing over-deflection of the actuator member.

In accordance with any embodiments, the device may comprise a memory for storing the known levels of deformation of the actuator member in response to the given set of actuation signal levels, and the known reductions in level of deformation in response to the given set of AC signal levels.

Examples in accordance with a further aspect of the invention provide an actuation method, which can be implemented in a computer program product.

### BRIEF DESCRIPTION OF THE DRAWINGS

Examples of the invention will now be described in detail with reference to the accompanying schematic drawings, in which:
Figs. 1 and 2 illustrate operating principles of EAP based actuators;
Fig. 3 shows actuation response of an example EAP actuator to applied DC actuation signal;
Fig. 4 shows actuation response and temperature variation of an example EAP actuator with an applied DC actuation signal;
Fig. 5 shows actuation response and temperature variation of an example EAP actuator for an applied DC actuation signal with different superposed AC signals;
Fig. 6 shows an example actuation device in accordance with one or more embodiments;
Fig. 7 shows temperature and deflection response of an example EAP actuator to AC signals of differing AC amplitudes;
Fig. 8 shows plots of temperature and deflection variation as a function of AC amplitude for the EAP actuator of Fig. 7;
Fig. 9 shows temperature and deflection response of an example EAP actuator to AC signals of differing AC frequencies; and
Fig. 10 shows plots of temperature and deflection variation as a function of AC frequency for the EAP actuator of Fig. 9.

### DETAILED DESCRIPTION OF THE EMBODIMENTS

The invention will be described with reference to the Figures.

The actuator device as defined herein comprises an actuator member which incorporates an electroactive material, usually mad of an electroactive polymer material. A controller controls supply of an actuation signal and a superposed AC signal. The actuator member has a known set of deformation or deflection responses to applied actuation signals of different levels, and a known set of oppositely direction deformation or deflection responses to applied AC signals of different levels. To achieve accelerated actuation response, an actuation signal is supplied of higher signal level than known to be necessary to realize a given desired actuation level, and an AC signal is supplied of a level sufficient to reduce the resultant actuation response to the desired level. In examples, the overdrive part of the actuation signal and the AC signal may be tapered off after realizing the desired actuation level.

The device makes use of electroactive polymers (EAPs) which, as noted above are a particular class of electroactive material. As noted, EAPs can work as sensors or actuators and can easily be manufactured into various shapes allowing easy integration into a large variety of systems.

Electroactive polymers can be subdivided into field-driven and ionic-driven materials.

Examples of field-driven EAPs include Piezoelectric polymers, Electrostrictive polymers (such as PVDF based relaxor polymers) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

Field-driven EAPs are actuated by an electric field through direct electromechanical coupling. They usually require high fields (volts per meter) but low currents. Polymer layers are usually thin to keep the driving voltage as low as possible.

Ionic EAPs are activated by an electrically induced transport of ions and/or solvent. They usually require low voltages but high currents. They require a liquid/gel electrolyte medium (although some material systems can also operate using solid electrolytes).

Both classes of EAP have multiple family members, each having their own advantages and disadvantages.

A first notable subclass of field-driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field-driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of field-driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrrole (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Altering the charge on the carbon atoms results in a change of C-C bond length. As a result, expansion and contraction of single CNT can be observed.

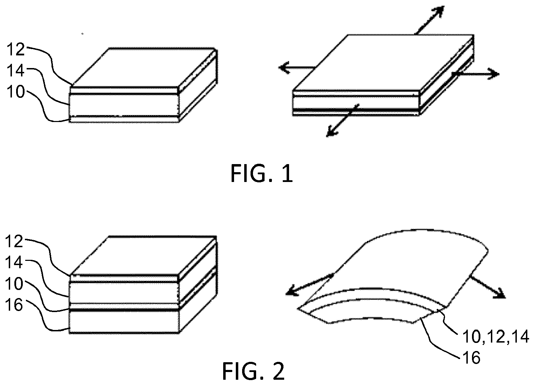

Figs. 1 and 2 show two possible operating modes for an EAP device.

The device comprises an electroactive polymer layer 14 sandwiched between electrodes 10, 12 on opposite sides of the electroactive polymer layer 14.

Fig. 1 shows a device which is not clamped. A voltage is used to cause the electroactive polymer layer to expand in all directions as shown.

Fig. 2 shows a device which is designed so that the expansion arises only in one direction. The device is supported by a carrier layer 16. A voltage is used to cause the electroactive polymer layer to curve or bow.

Together, the electrodes, electroactive polymer layer, and carrier may be considered to constitute the overall actuator member.

The nature of this movement for example arises from the interaction between the active layer, which expands when actuated, and the passive carrier layer. To obtain the asymmetric curving around an axis as shown, molecular orientation (film stretching) may for example be applied, forcing the movement in one direction.

The expansion in one direction may result from the asymmetry in the EAP polymer, or it may result from asymmetry in the properties of the carrier layer, or a combination of both.

An actuator member as described above may be used both for actuation and for sensing. The most prominent sensing mechanisms are based on force measurements and strain detection. Dielectric elastomers, for example, can be easily stretched by an external force. By putting a low voltage on the sensor, the strain can be measured as a function of voltage (the voltage is a function of the area).

Another way of sensing with field-driven systems is measuring the capacitance-change directly or measuring changes in electrode resistance as a function of strain.

Piezoelectric and electrostrictive polymer sensors can generate an electric charge in response to applied mechanical stress (given that the amount of crystallinity is high enough to generate a detectable charge). Conjugated polymers can make use of the piezo-ionic effect (mechanical stress leads to exertion of ions). CNTs experience a change of charge on the CNT surface when exposed to stress, which can be measured. It has also been shown that the resistance of CNTs change when in contact with gaseous molecules (e.g. 02, N02), making CNTs usable as gas detectors.

When an actuator of the type of Fig. 2 is driven from its rest state (first actuation state) to a desired actuation state (second actuation state), a controller or driver is utilized to provide a voltage (in general an actuation signal) known to result in a deformation of the actuator corresponding to that second actuation state.

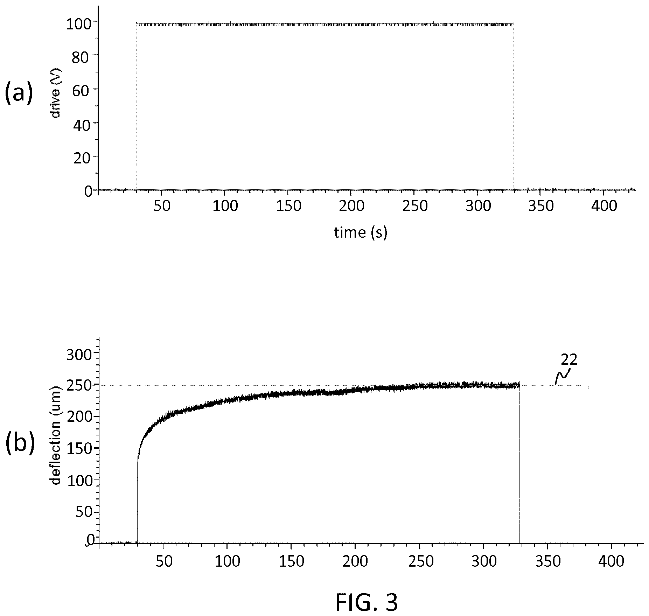

Fig. 3 illustrates (e.g. for an actuator having a field driven EAP) the displacement response as a function of time in response to supply of a step voltage of 100V. Fig. 3(a) shows the applied actuation voltage (y-axis; Volts) as a function of time (x-axis; seconds). Fig. 3(b) shows the deformation response of the actuator in terms of deflection of a free end of the actuator member. The graph shows deflection in micrometers (y-axis) as a function of time (x-axis; seconds).

Clearly, although a step voltage actuation (drive) signal is provided to the EAP member, its actuation output does not follow this step function. Instead, after an initial rapid actuation response, there follows a very slow upward drifting of actuation displacement toward the final displacement level (indicated by horizontal line 22). A more step-like or square displacement would be desirable.

Fig. 3 illustrates the significance of relaxation effects in the EAP in undermining stability of actuator position when drive voltage is held over time periods of longer than a few seconds. For relax or ferroelectric polymers, such as was used in generating the results of Fig. 3, there may be identified four different temporal regimes on a molecular level contributing to the overall displacement response:
1. Capacitive charging of the EAP (electrical loading increases). This lasts for only the first few seconds of supply of the actuation signal.
2. Orientation of the molecular chains inside the polymer crystallites.
3. Re-orientation of crystallite domains.
4. Mechanical relaxations of the (passive) glue layers and substrate in the actuator.

While the first two processes are fast (between milliseconds and seconds), the third and fourth processes are typically very slow (up to many minutes in duration, as shown in Fig. 3).

It will be clear that duration and extent of each of the four effects will differ per EAP material and structure. Thus, although the above effects are primarily applicable to relaxor ferroelectric polymers, the drive schemes of the invention described below can also be applied to other polymer actuators such as the class of dielectric elastomer actuators. In dielectric elastomer polymers, the dominant deformation mechanisms are Maxwell stress and mechanical relaxations. These result in a similar displacement response pattern as that of Fig. 3.

Embodiments of the present invention aim to overcome the delay in response of the EAP actuator in order to achieve a more step-like displacement response.

This is achieved by intentionally overdriving the actuator member with an actuation signal which is known to correspond to a higher final actuation displacement than is desired to be achieved at a particular instance. Due to the delayed response, the initial actuation deflection (within e.g. the first few seconds) is lower than the true final deflection. This initial deflection is achieved very fast (approximately step-like response) due to the overdriving. To reduce or preferably avoid over-deflecting after the first few seconds, there is further applied, superposed with the overdrive actuation signal, a relative high frequency AC signal which has the effect of reducing the actuation response, therewith reducing or preventing the over-deflection.

Without wanting to be bound by theory, it is believed that the AC signal causes heating of the actuator member, resulting in electrical losses. These electrical losses inhibit the actuation response of the actuator, effectively preventing the delayed part of the actuation response from occurring (if an AC signal of the correct strength is applied). Due to the relatively small mass and thermal insularity of the actuator member, heating may occur rapidly. In this combined way of overdriving and relaxation actuation, accelerated actuation is realized, while reducing or avoiding over-deflection.

It is known that electroactive polymers (EAPs) exhibit electrical losses when heated. Artificial heating can be stimulated by driving an EAP for instance with a continuous high frequency AC-voltage. Thus, the AC signal functions as a heating signal. These heat-induced electrical losses lead to degradation in actuation response: the extent of actuation for a given applied drive voltage is reduced when such AC signals are applied because electrical energy otherwise directed to actuation is instead lost through heat. If EAPs are driven continuously with an AC-voltage, these losses are mainly caused by a continuous capacitive (re) charging process of the EAP and a continuous (re) orientation of molecular chains inside the polymer crystallites. Without wanting to be bound by theory, it is believed that the AC signal induced relaxation as used in the invention is at least partly based on this heating mechanism.

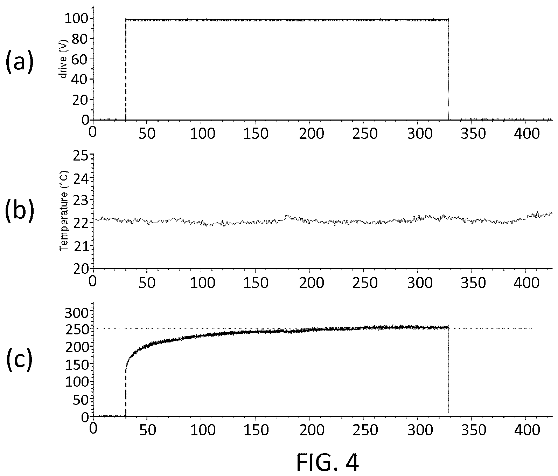

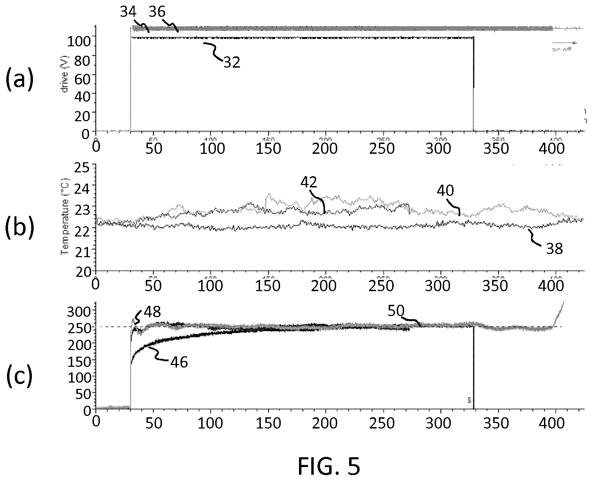

The performance of the proposed solution has been evaluated and proven through a set of simple test demonstrations, results of which will now be discussed with reference to Figs. 4 and 5. The tests made use of an EAP actuator (Novasentis^{™}) clamped at one end leaving a second end free to move (deflect) in directions about the clamped edge. The mechanical deflection of the free end of the actuator was measured using a chromatic optical measuring system (CHRocodile SE from Precitec^{™}), a sensing probe of the system being arranged above the EAP actuator.

A type K thermoelement was used to measure the (environmental) temperature directly beneath the EAP.

Standard mechanical deflection performance of the EAP actuator was first established by applying to the actuator a block waveform signal was used having a constant DC-voltage actuation signal of 100 V applied for approximately 300 seconds. Fig. 4 shows the results. The applied DC actuation signal is shown in Fig. 4(a) as applied voltage (y-axis; Volts) as a function of time (x-axis; seconds). The environmental temperature immediately beneath the actuator is shown in Fig. 4(b) as temperature (y-axis; degree Celsius) as a function of time (x-axis; seconds). The realized mechanical deflection of the actuator is shown in Fig. 4(c) as deflection of the free end of the actuator from its rest position (y-axis; micrometers) as a function of time (x-axis; seconds).

As shown, after an initial rapid deflection phase, a slower delayed deflection followed. An approximately steady-state deflection was reached only after approximately 5 minutes (300 seconds). During this time, the environmental temperature remained approximately constant.

Through experimentation, it has been recognized that deflection of EAPs exhibits a strong temperature dependency, i.e. mechanical deflection is influenced by environmental or operating temperature of the EAP. This is because heating of the EAP leads to energy losses, reducing the deflection capability for a given applied voltage or current.

Variation in the internal temperature of the EAP can be controlled by applying to the EAP a relatively high frequency AC signal. This has the effect of heating the EAP actuator. This AC signal can be superposed on the DC (or AC) actuation signal to achieve simultaneous heating and actuation. By controlling the (voltage) amplitude and/or frequency of the AC signal, level of heating can be adjusted, and the internal losses can thereby be controlled, allowing deflection response of the actuator to be configured.

Fig. 5 shows results of a simple test demonstration of this principle

Fig. 5(a) shows applied drive voltage to the EAP actuator (y-axis, Volts) as a function of time (x-axis; seconds).

Fig. 5(b) shows measured environmental temperature immediately below the EAP actuator as temperature (y-axis; degrees Celsius) as a function of time (x-axis; seconds).

Fig. 5(c) shows realized deflection of the free end of the EAP actuator (y-axis; micrometers) as a function of time (x-axis, seconds).

Three different plots are shown in each graph.

Lines 32, 38, 46 show applied drive voltage, environmental temperature and mechanical deflection respectively for a control case in which no actuation overdriving was applied and no AC signal. These plots are identical to the results shown in Fig. 4 and are presented for ease of comparison.

Lines 34, 40, and 48 show applied drive voltage, environmental temperature and mechanical deflection for a case in which a DC drive signal was applied at a voltage 10% higher than that of the control case (i.e. with a 10% overdrive) and superposed with a (sinusoidal) AC signal in which frequency of the signal was varied in order to control the level of heating. The DC actuation signal was applied at 110V rather than 100V. As shown in Fig.(c), line 48, the desired deflection (deformation) level of approximately 250 micrometers is realized very much faster than in the control case; this level is reached within the first few seconds, compared to the five minutes taken in the control case. A very slight mechanical overshoot occurs due to the higher drive signal. However, this is rapidly compensated by the applied AC signal whose frequency is adjusted to bring the deflection back down to the 250 micrometer deflection level.

Lines 36, 42 and 50 show applied drive voltage, environmental temperature and mechanical deflection respectively for a case in which a DC drive signal was again applied at a voltage 10% higher than that of the control case (10% actuation signal overdrive) and superposed with an AC signal in which amplitude of the signal was varied in order to control the level of heating. The DC actuation signal was again applied at 110V rather than 100V. The actuation signal 36 is not visible beneath the overlaid line 34 in the graph of Fig. 5(a). As shown in Fig. 5(c), line 48, the desired deformation level of approximately 250 micrometers is again realized very rapidly, within the first few seconds, compared to the five minutes taken in the control case. No initial mechanical overshoot occurs in this case, although there is some oscillation around the deflection level as time progresses. This is compensated by the applied AC signal whose amplitude is varied in order to keep the deflection at the 250 micrometer level.

The AC signal amplitude and/or frequency can thus be adjusted or tuned to achieve the desired thermal effect and reduce or maintain the mechanical deflection at the desired set-point of the EAP.

The optimization of AC signal frequency and or amplitude can be set or controlled to provide a desired thermal relaxation effect of the EAP to give for example a minimal overshoot or fastest response of deflection a particular overdrive level and particular desired final actuation level. Calibration for multiple such levels can be performed in such manner.

For the case in which frequency of the AC signal was adjusted, the AC frequency was varied in the range 10 kHz to 100 kHz, at fixed AC peak-to-peak amplitude of 10V.

For the case in which amplitude of the AC signal was adjusted, the AC peak-to-peak amplitude was varied in the range 1V to 10V, at a fixed AC frequency of 20kHz.

Thus it can be seen that by applying a small (e.g. 10%) overdriven actuation signal, superposed with an AC-signal, the original deflection reaction time can be very significantly reduced, from around 5 minutes to less than 10 seconds.

It is noted that although a sinusoidal AC signal was applied in the test case of Fig. 5, a different shape of (alternating) AC signal (e.g. triangular, block wave etc) may alternatively be applied in other examples.

More details concerning suitable frequencies, amplitudes and drive regimes for the AC signal and the actuation signal will be outlined in passages to follow.

There will now be described an example actuation device in accordance with one or more embodiments, implementing the above described control principles.

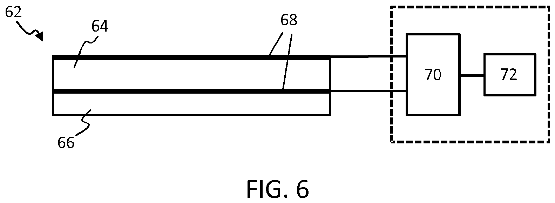

Fig. 6 shows such an example actuation device.

The device comprises an actuator member 62, comprising an active EAP layer 64 coupled to a passive backing layer 66. An electrode arrangement in form of a pair of electrodes 66 surrounds the active EAP layer 64 for applying the actuation and AC (heating) signals in the form of an electric field across the EAP layer. The electric field stimulates deformation and thereby actuation of the EAP layer when the field is constant or at relatively low frequency, and stimulates heating when the field is relatively high frequency. The backing layer 56 constricts in-plane expansion of the EAP layer, thereby inducing a bending actuation action upon deformation of the EAP layer by the actuation signal.

Although electrodes are provided for generating an electric field across the EAP layer, in alternative examples, the device may be configured for applying electrical currents through the EAP layer (in the case of ionic EAPs for instance).

The electrodes 62 are electrically coupled to an electrical supply means 70 for supplying the actuation signal and AC signal to the EAP layer of the actuator member 62. The electrical supply means may in examples comprise a power source, or may comprise a port or electrical connection for connecting an external power supply for instance.

The electrical supply means 70 is operatively coupled to a controller 72 adapted to control electrical stimulation of the actuator member 62 using the electrical supply means 70.

Although the electrical supply means 70 and controller 72 are separate components in the example of Fig. 6, in alternative examples, the functionality of both may be provided by a single component, e.g. a single controller having integrated electrical supply means.

The actuator member 62 exhibits at least one, but preferably a set of known levels of deformation in response to a given set of actuation signal levels, and exhibits a known reduction in the level of deformation in response to a given set of AC signal levels. The AC signal levels may correspond to signal amplitudes or frequencies or a combination of both.

In use, the controller 72 is adapted to control the actuator member 62 to deform (deflect) to a given level (first level of deformation) by supplying an actuation signal (second actuation signal) of a level greater than necessary to achieve the given deformation (deflection) level (first level of deformation) and supplying an AC signal with a level sufficient to reduce a deformation level achieved by providing the second actuation signal to said given deformation level, the applied actuation and AC signal levels being derived based on the known set of actuator member deformation responses.

For a particular actuation signal or signal level, the levels of deformation/deflection can exist under conditions of no actuator load, i.e. when the actuator is in free-state, such as when the device is not in its intended use position. Likewise there may be levels of deformation/deflection for this signal or signal level under load conditions and these latter deformation/deflection may be the same or different from those achieved without load. This difference may be dependent on the load. In any case there is a set of actuation levels which can be manipulated using the combination of overdriving and AC relaxation driving.

The device may comprise a memory in which the known deformation responses to different actuation signal and AC signal levels are stored.

There may for instance be stored a look-up table facilitating mapping of respective signal level to deformation response. Or the response may be calculated based on stored functional relations between respective signal level and deformation response (e.g. level of deformation or change in deformation level).

Additionally or alternatively, the device may comprise communication means for communicating with an external (e.g. remote) computer or server in order for obtaining or receiving the known signal responses.

In some examples, simply a discrete set of actuation level responses for a given set of actuation signal and AC signal levels may be known (e.g. stored in a memory). In these cases, a required actuation signal level to achieve a particular actuation level which lies between or outside known points may be derived through simple interpolation or extrapolation.

Actuation responses may in examples be derived in advance through experiment or calculation.

After initial application of the overdriven actuation signal and compensatory AC signal, the two are progressively tapered (reduced in strength or magnitude) in order to avoid drift of the actuator member away from the desired displacement level. The aim is to gradually reduce the signals once the given (desired) actuation level is reached. The deformation will slowly increase with time due to the delayed response of EAP to the supplied signal. The tapering avoids drift of the actuator member away from the reached deformation level.

Preferably, the rate of tapering of one or both of the actuation signal and AC signal is determined based on a known actuation level increase as a function of time for the initially supplied actuation signal. In particular, the deformation-time response of the actuator (i.e. the trace shown in Fig. 4) is preferably known or determined in advance for the actuator in question.

The rate of increase of deflection after the initial few seconds can be derived from this, and the applied overdrive signal can be gradually reduced in voltage at a corresponding rate, so that the two effectively nullify one another and deflection remains at a constant level. This reciprocal reduction in drive voltage as deflection slowly drifts upwards is continued until the actuator has fully deflected (e.g. after approximately 5 minutes in the example of Fig. 4 and Fig. 5), at which point the overdrive part of the actuation signal has been reduced to zero, leaving the actuator steady at the final deflection level.

The AC signal is also tapered at the same rate as the overdrive part of the actuation signal, such that two reach zero at approximately the same time, this corresponding with the time at which the actuator has reached its fully relaxed actuation state.

For the avoidance of doubt, the term 'overdrive part' of the actuation signal means the additional voltage added the signal on top of that required to achieve the desired final deflection position. For example, in the test case of Fig. 5, an actuation signal 10% higher than required was applied.

The tapering may be almost instantaneous, e.g. using s step signal change.

The tapering of the actuation and AC signals may in examples be performed after a given time delay, or upon determining that said given deformation level has been reached.

Tapering of the actuation signal and AC signal may be performed synchronously and at a corresponding rate. By synchronously is meant starting at the same time. By corresponding rate is meant exhibiting the same proportional decrease in level per unit time.

Embodiments of the invention rely upon there being known in advance the actuation response behavior of the EAP actuator to both actuation drive signals of different drive voltages and AC signals of different amplitudes and/or voltages.

There will now be described example routine calibration experiments which may be performed in order to determine response characteristics of an actuator to different AC signal levels. This may be combined with results obtained in a simple control experiment such as in Fig. 3 to determine response of the actuator over time to both different actuation and AC signal levels.

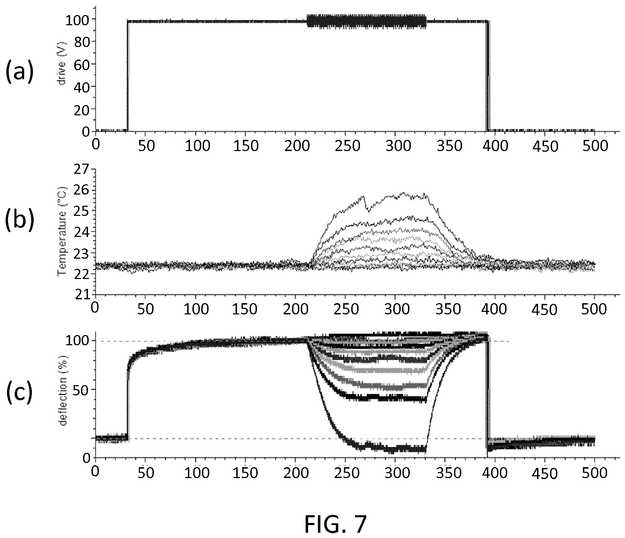

Fig. 7 shows results for systematically varying the AC amplitude of an AC signal applied at constant AC frequency of 20 kHz, and superposed on an example DC actuation signal (of 100V). The AC signal was applied only after the actuator had reached its final (100%) deflection position, in order to determine the (negative) deflection response to the AC signal.

The graphs show deflection behavior for ten different AC amplitudes, of integer voltage amplitude from 0 to 10V, each represented by a separate respective line on each of the graphs.

Fig. 7(a) shows the applied DC actuation + AC signals for each of the different AC signal amplitudes, with the y-axis showing voltage (V) and the x-axis showing time (seconds). It is not possible to see all of the different signals, due to the overlap between them.

Fig. 7(b) shows the environmental temperature immediately below the EAP actuator (y-axis; degrees Celsius) as a function of time (x-axis; seconds). The shown ten lines correspond to applied AC signals in ascending order of amplitude, from 0V peak-to-peak amplitude at the lowest line to 10V amplitude at the highest line. It is clear therefore that the higher the amplitude, the higher the resulting heating effect in the EAP actuator.

Fig. 7(c) shows the deflection of the EAP actuator, in terms of percentage of its final deflection level (y-axis; %), as a function of time (seconds). The ten lines in this case are in descending order of AC amplitude, from 10V amplitude as the lowest line to 0V amplitude as the highest line.

These results were achieved by operating the EAP actuator at a fixed DC actuation voltage of 100V. After reaching an almost stable mechanical deflection level at around 210 seconds, the AC signal was switched on (superposed with the DC actuation signal) and the (negative) change of the mechanical deflection was recorded. In addition, the variation in environmental temperature (caused by the AC-induced internal heating of the EAP) is also recorded. Note that this is the environmental temperature, thus the internal temperature of the EAP may be significantly higher.

It can be seen, that even a very small AC-amplitude of only 1 V (peak-to-peak) results in a slight degradation (reduction) in the mechanical deflection (see second line from the top in Fig. 7(c)), although no change of the environmental temperature could be recognized. As AC signal amplitude is increased, the deflection degrades to an ever greater extent. At an amplitude of 3 Volts, a small increase in the environmental temperature could be seen, and a slightly larger deflection degradation (third line from top in Fig. 7(c)). Finally, at high amplitudes, e.g. 10 V (bottom-most line in Fig. 7(c)), the EAP even deflects towards the opposite direction (i.e. more than 100% of the total deflection is countered). Thus it can be seen that the full range of possible negative deformation adjustments (for avoiding over-deflection due to the actuation signal overdriving) can be achieved through appropriately varying the AC signal amplitude.

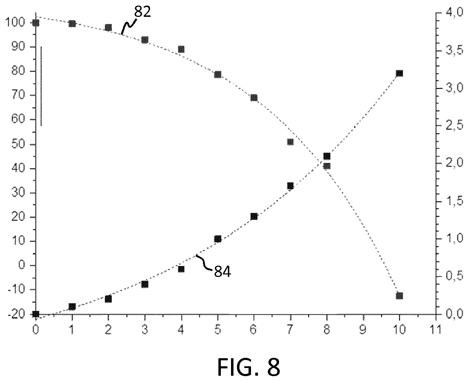

Fig. 8 shows the mechanical deflection (y-axis, left; % of maximum deflection) and change in environmental temperature (y-axis, right; degrees Celsius) as a function of the superposed AC-signal peak-to-peak amplitude (x-axis; Volts).

Line 82 shows the variation in deflection response with AC signal amplitude. Line 84 shows the change in (environmental) temperature a function of amplitude.

The solid boxes in the graph show the discrete measurement points taken within the investigation. To derive a full range of actuation (and temperature) responses to different AC signal amplitudes, numerical fits are plotted between the lines which identify clear trends. It can be seen that the deflection 82 follows an exponential decrease, while the environmental temperature 84 (and thus the internal EAP temperature) follows an exponential growth.

It will be recognized that the above presented experiment represents routine experimentation which may be readily performed, without undue burden, by the skilled person in order to determine actuation responses of any particular EAP actuator to be used in the actuation device, to AC signals of different amplitudes and/or frequencies.

As noted above, the level of heating of the EAP actuator, and hence the negative deformation effect, can be varied either by adjusting the AC signal amplitude (as above) or by adjusting the AC signal frequency.

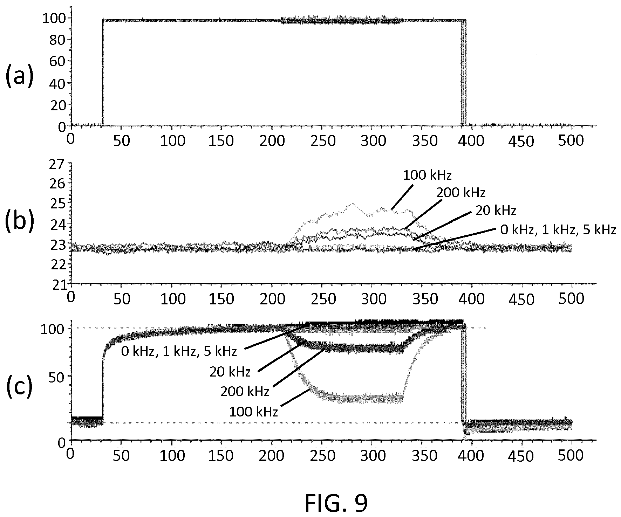

Fig. 9 shows results for systematically varying the AC frequency of an AC signal applied at constant AC amplitude of 5V and superposed on an example DC actuation signal (of 100V). The AC signal was again applied only after the actuator had reached its final (100%) natural deflection position, in order to determine the (negative) deflection response to the AC signal.

The graphs show deflection behavior for six different AC frequencies: 0 kHz, 1 kHz, 5 kHz, 20 kHz, 100 kHz and 200 kHz. Each is represented by a separate respective line on each of the graphs.

Fig. 9(a) shows applied the applied DC actuation + AC signals for each of the different AC signal frequencies, with the y-axis showing voltage (V) and the x-axis showing time (seconds). It is again not possible to see all of the different signals, due to the overlap of the respective signals.

Fig. 9(b) shows the environmental temperature immediately below the EAP actuator (y-axis; degrees Celsius) as a function of time (x-axis; seconds). The shown six lines correspond to applied AC signals for the different frequencies. The frequencies of the lines are labelled in the figure.

Fig. 9(c) shows the deflection of the EAP actuator, in terms of percentage of its final deflection level (y-axis; %), as a function of time (seconds). The six lines in this case are again labelled in terms of the AC signal frequency to which each corresponds.

These results were achieved by operating the EAP actuator at a fixed DC actuation voltage of 100V. After reaching an almost stable mechanical deflection level at around 210 seconds, the AC signal was switched on (superposed with the DC actuation signal) and the (negative) change of the mechanical deflection was recorded. In addition, the variation in environmental temperature (caused by the AC-induced internal heating of the EAP) is also recorded. Note that this is the environmental temperature, thus the internal temperature of the EAP may be significantly higher.

It can be seen, that even a very low AC-frequency of only 1 kHz results in a slight degradation (reduction) in the mechanical deflection (see Fig. 9(c)), although no change of the environmental temperature could be recognized. This is because this low frequency is below the maximum mechanical switching frequency of the actuator, meaning that the signal is mostly transformed into vibration of the actuator, rather than heat losses.

At 5 kHz, a small temperature increase can be seen, however the signal is still below the maximum switching frequency of the actuator.

At higher frequencies of e.g. 20 kHz and in particular 100 kHz the loss mechanism become dominant (over vibration), as can be seen by the large negative deflection effect for these frequencies in Fig. 9(c).

At even higher frequencies (e.g. 200 kHz), it can be seen that the temperature and deflection response reduce back to a level realized by a signal of frequency around 20 kHz. Hence the deflection response is not linear with increasing frequency; the response peaks at a frequency of around 100 kHz. This is because the continuous (re) orientation of the molecular chains inside the polymer crystallites become less dominant above this frequency, reducing the internal losses and thus the heat generation.

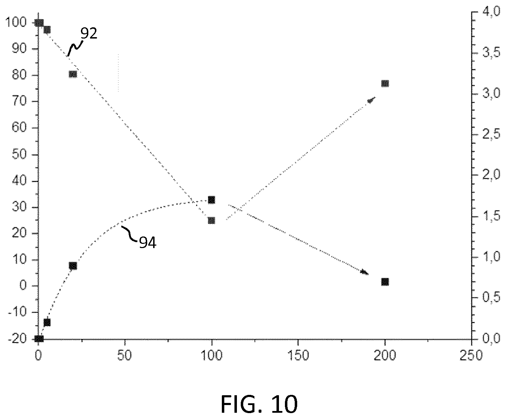

This is illustrated more clearly in Fig. 10, which shows the mechanical deflection (y-axis, left; % of maximum deflection) and change in environmental temperature (y-axis, right; degrees Celsius) as a function of the superposed AC-frequency (x-axis; kHz)

Line 92 shows the variation in deflection response with AC signal frequency. Line 94 shows the change in (environmental) temperature a function of frequency.

The solid boxes in the graph show the discrete measurement points taken within the investigation. To derive a full range of actuation (and temperature) responses to different frequencies, numerical fits are plotted between the lines which identify clear trends. It can be seen that the deflection 92 follows a linear decrease between 0 kHz and around 100 kHz, whereas the environmental temperature 94 (and thus the internal EAP temperature) follows an exponential growth pattern up to around 100 kHz. After around 100 kHz, the trend lines change, since the re-orientation of crystallite domains can no more follow the applied AC-frequency.

It should be noted that the particular AC-amplitudes and frequencies identified correspond to the particular investigated EAP sample. Other EAPs may react differently and accordingly different AC-amplitudes and frequencies may need to be used in order to achieve similar effects.

It will again be recognized that the above presented experiment represents routine experimentation which may be readily performed, without undue burden, by the skilled person in order to determine actuation responses of any particular EAP actuator to be used in the actuation device, to AC signals of different amplitudes and/or frequencies. In this way, either a set of known actuation responses can be derived for a discrete set of different applied AC signal amplitudes or frequencies, or through simple interpolation (as in Figs. 8 and 10), a continuous plot of actuation response as a function of changing AC signal frequency or amplitude can be obtained. Deformation responses for different actuation signal levels can be obtained in a similar way, by measuring variation in deflection of the given EAP actuator as a function of time for different actuation signal levels (e.g. different voltage or current levels).

In the above examples, an actuation signal overdrive of 10% was exemplarily used (i.e. an actuation signal was applied at a level 10% greater than known to be necessary to achieve the desired deformation level). However, in alternative examples, different actuation signal overdrives may be used. Such additional part can be 2, 5, 10, 20, or 50 % of the signal level. The actual overdrive used can be dependent on the type of actuator and for example can be set according to the increase of switch speed required. Preferably, the actuation signal overdrive is between 8 and 12%. An overdrive of 10% or less has been found to reliably accelerate signals without causing damage to the EAP material by applying too high a voltage.

In accordance with one or more embodiments, the controller may be adapted to begin supply of the AC signal slightly in advance of supply of the actuation signal (e.g. a few seconds in advance). This results in a "feed forward approach", wherein AC actuation, to result in heating, is pre-applied to the actuator member, generating an initial negative offset in actuation position. Applying the overdriven actuation signal then results in actuation to exactly the desired actuation level (almost) immediately upon applying the actuation signal. This approach may reduce instance of initially overshooting of the deflection positon, since there is no delay time waiting for the actuator member to heat up and the negative deflection to take effect. By pre-heating, the compensatory effect is already in place before actuation begins.

In accordance with one or more embodiments, the driving approach of the present invention may be combined with other driving modes also making use of electrical overdriving for accelerating the actuation response. The controller may for instance be operable in different modes, wherein in accordance with one control mode, a drive scheme in accordance with examples outlined above is implemented, and, in accordance with a different control mode, a drive scheme in accordance with an example outlined below is implemented. This increases the flexibility and widens the operating capabilities of the device. The different control modes may be user-selectable in examples, for instance using a user interface element, or may be selected autonomously by the controller for instance based on programmed decision criteria.

For example, the controller may in some examples be adapted to control the voltage supply means to provide a first drive voltage for charging the actuator member from a non-actuated state to an actuated state; and
when or after the actuator member reaches the actuated state to provide a second drive voltage lower than the first drive voltage for holding the member at the actuated state.

In this way, the actuator member is controlled to reduce the delay in reaching an actuated state. The first drive voltage may be considered to be an overdrive voltage, but it is of limited duration. This means that the voltage across an effective capacitance of the actuator member may not reach the first drive level, because the drive level is reduced beforehand. The drive scheme thus takes account of the capacitive nature of the EAP structure, which is actuated by charge injection. By increasing the drive voltage, additional charge is delivered to the actuator member, but without the voltage across the actuator member exceeding limits.

The second drive voltage in this drive scheme may be constant, but it may instead have a profile over time.

The controller is for example adapted to provide the second drive voltage for at least as long as the first drive voltage, and more preferably for at least twice as long as the first drive voltage.

Thus, the actuation is essentially a low frequency driving of the actuator, in the sense that the complete actuation is much longer that the overdrive duration, and the voltage across the actuator member stabilizes.

The voltage across an effective capacitance of the actuator member may be at or below the second drive voltage while the actuator member is charging. Thus, even though the first drive voltage is larger than is needed to reach a desired actuation state, the capacitance of the actuator member is never exposed to this voltage.

Instead, the controller may be adapted to apply the first drive voltage until the voltage across an effective capacitance of the actuator member exceeds the second drive voltage by a predetermined amount, such that the voltage drops back to the second drive voltage subsequently, e.g. while the second drive voltage is applied or while a lower voltage is applied. This provides a temporary overdrive voltage across the capacitance of the actuator member.

In accordance with further examples, the controller may be operable in a further control mode in which the controller is adapted to control supply of an actuation signal at an overdrive voltage for accelerated actuation and to subsequently drop the voltage level to a lower level to prevent over-deflection.

In preferred examples, the intermediate level may be at least 5% higher than the second level and the second period may be equal to or longer than 0.5 seconds.

In both of the above sets of possible optional control modes for driving the actuator member, accelerated response is achieved by first applying an overdriven actuation signal (of higher signal level than necessary to achieve the desired deflection level). Over-deflection is then avoided, not using an AC signal (as in the main concept of the present invention), but by simply reducing the actuation signal level after some delay or by subsequently applying a second actuation signal of lower drive voltage than the first (overdriven) actuation signal.

The driving has been explained with an example actuator of the field driven type and using voltage driving, i.e. voltage signals were set and used to achieve the actuation. However, the driving is not limited to such actuators or voltage driving. It may also be used for current controlled actuators requiring current driving. For example there may be an actuator requiring a current to be set to have it achieve a particular actuation response. The AC signal can still be used to cause the relaxation in such cases. Such devices may require a current source as the power supply means and this may be implemented together with a controller to operate in an analogous way as described above for the voltage driven actuators.

As noted, one or both of the above described drive modes may be incorporated in embodiments of the invention as additional optional control modes of the controller, wherein in accordance with a first control mode, the controller is adapted to implement a control scheme according to one or more of the embodiments outlined previously, and in accordance with a further control scheme is adapted to implement one of the above alternative control schemes above.

This invention relates in particular to actuation of EAP actuators. However, it can be used in applications where an EAP device is performing both a sensing and an actuation function.

Although in the detailed description herein above the construction and operation of devices and systems according to the invention have been described for EAPs, the invention can in fact be used for devices based on other kinds of EAM material. Hence, unless indicated otherwise, the EAP materials hereinabove can be replaced with other EAM materials. Such other EAM materials are known in the art and the person skilled in the art will know where to find them and how to apply them.

Materials suitable for an EAP actuator (e.g. an EAP layer of an actuator member) are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:
Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to:
acrylates, polyurethanes, silicones.

The sub-class conjugated polymers includes, but is not limited to:
polypyrrole, poly-3,4-ethylenedioxythiophene, poly(p-phenylene sulfide), polyanilines.

In all of these examples, additional passive layers may be provided for influencing the electrical and/or mechanical behavior of the EAP layer in response to an applied electric field.

The EAP layer of each unit may be sandwiched between electrodes. The electrodes may be stretchable so that they follow the deformation of the EAP material layer. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

If the electrodes are arranged in a non-symmetric configuration, the imposed voltage can induce all kinds of deformations such as twisting, rolling, torsioning, turning, and non-symmetric bending deformation.

The invention can be applied in many EAP and polymer applications, including examples where a passive matrix array of actuators is of interest.

In many applications the main function of the product relies on the (local) manipulation of human tissue, or the actuation of tissue contacting interfaces. In such applications EAP actuators for example provide unique benefits mainly because of the small form factor, the flexibility and the high energy density. Hence EAPs and photoresponsive polymers can be easily integrated in soft, 3D-shaped and / or miniature products and interfaces. Examples of such applications are:
Skin cosmetic treatments such as skin actuation devices in the form of a responsive polymer based skin patches which apply a constant or cyclic stretch to the skin in order to tension the skin or to reduce wrinkles;
Respiratory devices with a patient interface mask which has a responsive polymer based active cushion or seal, to provide an alternating normal pressure to the skin which reduces or prevents facial red marks;
Electric shavers with an adaptive shaving head. The height of the skin contacting surfaces can be adjusted using responsive polymer actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of responsive polymer transducers which is integrated in or near the user interface;
Catheters with a steerable tip to enable easy navigation in tortuous blood vessels;
Measurements of physiological human body parameters such as heart beat, SpO2 and blood pressure.

Another category of relevant application which benefits from such actuators relates to the modification of light. Optical elements such as lenses, reflective surfaces, gratings etc. can be made adaptive by shape or position adaptation using these actuators. Here one benefit of EAPs for example is a lower power consumption.

More broadly, the invention is susceptible to a wide range of possible applications. Any device in which very rapid actuation, with stable and precise actuation position is required may advantageously make use of embodiments of the invention.

Example applications in which the invention may be particularly advantageously applied include personal care devices (e.g. shaver, trimmer, skin care devices), oral healthcare devices (e.g. toothbrush, tongue-cleaner, mouth piece, air floss device), personal health devices (e.g. handheld devices, wearables), medical devices (e.g. catheters, CMUT devices), (Micro-) mirror positioning and (miniature) fluid valve control.

As discussed above, embodiments make use of a controller. The controller can be implemented in numerous ways, with software and/or hardware, to perform the various functions required. A processor is one example of a controller which employs one or more microprocessors that may be programmed using software (e.g., microcode) to perform the required functions. A controller may however be implemented with or without employing a processor, and also may be implemented as a combination of dedicated hardware to perform some functions and a processor (e.g., one or more programmed microprocessors and associated circuitry) to perform other functions.

Examples of controller components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media such as volatile and non-volatile computer memory such as RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor or controller.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An actuator device, comprising:
an actuator member (62) comprising an electroactive material (64) that is deformable in that it changes in size and/or shape in response to an electrical signal, the actuator member (62) being arranged for exhibiting a first level of deformation in response to the electrical signal being a first actuation signal, a second level of deformation that is higher than the first level of deformation, in response to the electrical signal being a second actuation signal, and a one-way reduction from the second level of deformation to the first level of deformation in response to the electrical signal including an AC signal;
electrical supply means (70) for supplying the electrical signal to the actuator member (62); and
a controller (72) for controlling the electrical supply means (70);
wherein the controller (72) is adapted to cause the electrical supply means (70) to provide to the actuator member (62) the electrical signal being the second actuation signal at least partly superposed with the AC signal to therewith achieve the first level of deformation, whereby the controller is configured to control the actuator member (62) to deform to the first level of deformation by supplying the second actuation signal suitable for arranging the actuator member (62) to exhibit the second level of deformation that is higher than the first level of deformation, and supplying the AC signal to arrive at the first level of deformation.

2. An actuator device as claimed in claim 1, wherein the AC signal is a heating signal for inducing heating of the actuator member (62).

3. An actuator device as claimed in claim 1 or 2, wherein the controller (72) is further adapted to taper the supplied second actuation signal and AC signal after their application such as to maintain the actuator member (62) at said given deformation level.

4. An actuator device as claimed in claim 3, wherein the controller (72) is further adapted to determine the rate of tapering of one or both of the second actuation signal and AC signal based on a known actuation level increase as a function of time for the initially supplied second actuation signal.

5. An actuator device as claimed in claim 3 or 4, wherein the controller (72) is further adapted to reduce the second actuation signal to the level required for achieving the first actuation level, and reduce the AC signal level to zero.

6. An actuator device as claimed in any of claims 3 to 5, wherein the controller (72) is further adapted to perform the tapering of the second actuation signal and the AC signal after a given time delay, or upon determining that said first deformation level has been reached.

7. An actuator device as claimed in any of claims 3 to 6, wherein the controller (72) is further adapted to perform the tapering of the second actuation signal and the AC signal synchronously and at a corresponding rate.

8. An actuator device as claimed in any preceding claim, wherein the actuator member (62) is arranged for exhibiting a known variation in level of deformation as a function of actuation signal level, and wherein the actuator member (62) is arranged for exhibiting a known reduction in deformation level as a function of AC signal level.

9. An actuator device as claimed in any preceding claim, wherein the controller (72) is adapted to supply the second actuation signal with a level no greater than 12% higher than the first actuation signal level, and preferably with a level between 8% and 12% higher than the first signal level.

10. An actuator device as claimed in any preceding claim, wherein the electrical supply means (70) is arranged for supplying the second actuation signal and the AC signal to the actuator member (62) synchronously.

11. An actuator device as claimed in any preceding claim, wherein the electrical supply means (70) is arranged for supplying the second actuation signal and the AC signal to the actuator member (62) asynchronously, and optionally wherein he electrical supply means (70) is arranged for beginning to supply the AC signal in advance of supply of the second actuation signal.

12. An actuator device as claimed in any preceding claim, wherein the device comprises a memory or lookup table for storing the first and second levels of deformation of the actuator member (62) in response to the first and second actuation signals and for storing the AC signal.

13. An actuation method for an actuator device that comprises an actuator member (62) comprising an electroactive material (64) that is deformable in that it changes in size and/or shape in response to an electrical signal, the actuator member (62) being arranged for exhibiting a first level of deformation in response to the electrical signal being a first actuation signal, a second level of deformation that is higher than the first level of deformation in response to the electrical signal being a second actuation signal, and a one-way reduction from the second level of deformation to the first level of deformation in response to the electrical signal including an AC signal; electrical supply means (70) for supplying the electrical signal to the actuator member (62); and a controller (72) for controlling the electrical supply means (70), wherein the method comprises:
causing the electrical supply means (70) to provide to the actuator member (62) the second actuation signal at least partly superposed with the AC signal to therewith achieve the first level of deformation, whereby the controller controls the actuator member (62) to deform to the first level of deformation by supplying the second actuation signal suitable for arranging the actuator member (62) to exhibit the second level of deformation that is higher than the first level of deformation, and supplying the AC signal to arrive at the first level of deformation.

14. An actuation method as claimed in claim 13, further comprising tapering the supplied second actuation signal and AC signal after their application such as to maintain the actuator member (62) at the first level of deformation.

15. An actuation method as claimed in claim 14, the tapering comprises reducing the second actuation signal to the level required for achieving the first actuation level, and reducing the AC signal level to zero.

16. A computer program product comprising computer readable code stored on, or storable on a computer readable medium, or downloadable from a network, which code, when executed by a controller, causes the controller to perform the steps of the method of any one of claims 13 to 15.

## Patentansprüche

1. Stellantriebsvorrichtung, umfassend:
ein Stellantriebselement (62), das ein elektroaktives Material (64) umfasst, das dahingehend verformbar ist, dass es seine Größe und/oder Form als Reaktion auf ein elektrisches Signal ändert, wobei das Stellantriebselement (62) so eingerichtet ist, dass es als Reaktion darauf, dass das elektrische Signal ein erstes Stellantriebssignal ist, einen ersten Grad an Verformung, als Reaktion darauf, dass das elektrische Signal ein zweites Stellantriebssignal ist, einen zweiten Grad an Verformung und als Reaktion darauf, dass das elektrische Signal ein Wechselstromsignal enthält, eine einseitig gerichtete Verringerung von dem zweiten Grad an Verformung auf den ersten Grad an Verformung zeigt;
eine elektrische Einspeisungseinrichtung (70) zum Einspeisen des elektrischen Signals in das Stellantriebselement (62); und
eine Steuerung (72) zum Steuern der elektrischen Einspeisungseinrichtung (70);
wobei die Steuerung (72) dafür ausgelegt ist, die elektrische Einspeisungseinrichtung (70) zu veranlassen, das elektrische Signal, bei dem es sich um das zweite Stellantriebssignal handelt, das zumindest zum Teil mit dem Wechselstromsignal überlagert ist, in das Stellantriebselement (62) einzuspeisen, um dadurch den ersten Grad an Verformung zu erreichen, wobei die Steuerung so konfiguriert ist, dass sie durch Einspeisen des zweiten Stellantriebssignals, das dafür geeignet ist, das Stellantriebselement (62) so einzurichten, dass es den zweiten Grad an Verformung zeigt, der höher ist als der erste Grad an Verformung, und Einspeisen des Wechselstromsignals, um bei dem ersten Grad an Verformung anzukommen, das Stellantriebselement (62) so steuert, dass es sich auf den ersten Grad an Verformung verformt.

2. Stellantriebsvorrichtung nach Anspruch 1, wobei das Wechselstromsignal ein Heizsignal zum Hervorrufen einer Erwärmung des Stellantriebselements (62) ist.

3. Stellantriebsvorrichtung nach Anspruch 1 oder 2, wobei die Steuerung (72) ferner dafür ausgelegt ist, das eingespeiste zweite Stellantriebssignal und das Wechselstromsignal nach deren Anlegung abzuschwächen, um das Stellantriebselement (62) bei dem gegebenen Grad an Verformung zu halten.

4. Stellantriebsvorrichtung nach Anspruch 3, wobei die Steuerung (72) ferner dafür ausgelegt ist, die Rate der Abschwächung von einem oder von beiden von dem zweiten Stellantriebssignal und dem Wechselstromsignal auf Basis eines bekannten, zeitabhängigen Anstiegs des Grades der Verstellung für das zu Anfang eingespeiste zweite Stellantriebssignal zu bestimmen.

5. Stellantriebsvorrichtung nach Anspruch 3 oder 4, wobei die Steuerung (72) ferner dafür ausgelegt ist, das zweite Stellantriebssignal auf den Pegel zu verringern, der nötig ist, um den ersten Grad an Verstellung zu erreichen, und das Wechselstromsignalpegels auf null zu verringern.

6. Stellantriebsvorrichtung nach einem der Ansprüche 3 bis 5, wobei die Steuerung (72) ferner dafür ausgelegt ist, die Abschwächung des zweiten Stellantriebssignals und des Wechselstromsignals nach einer gewissen Verzögerung oder nach einer Bestimmung, dass der zweite Grad der Verformung erreicht worden ist, durchzuführen.

7. Stellantriebsvorrichtung nach einem der Ansprüche 3 bis 6, wobei die Steuerung (72) ferner dafür ausgelegt ist, die Abschwächung des zweiten Stellantriebssignals und des Wechselstromsignals synchron und mit einer entsprechenden Rate durchzuführen.

8. Stellantriebsvorrichtung nach einem der vorangehenden Ansprüche, wobei das Stellantriebselement (62) so eingerichtet ist, dass es eine bekannte Variation des Grades der Verformung als Funktion eines Stellantriebssignalpegels zeigt, und wobei das Stellantriebselement (62) so eingerichtet ist, dass es eine bekannte Verringerung des Grades der Verformung als Funktion eines Wechselstromsignalpegels zeigt.

9. Stellantriebsvorrichtung nach einem der vorangehenden Ansprüche, wobei die Steuerung (72) dafür ausgelegt ist, das zweite Stellantriebssignal mit einem Pegel einzuspeisen, der um nicht mehr als 12% höher ist als der Pegel des ersten Stellantriebssignals, und vorzugsweise mit einem Pegel, der 8% und 12% höher ist als der erste Pegel des ersten Signals.

10. Stellantriebsvorrichtung nach einem der vorangehenden Ansprüche, wobei die Stromeinspeisungseinrichtung (70) dafür eingerichtet ist, das zweite Stellantriebssignal und das Wechselstromsignal synchron in das Stellantriebselement (62) einzuspeisen.

11. Stellantriebsvorrichtung nach einem der vorangehenden Ansprüche, wobei die Stromeinspeisungseinrichtung (70) dafür eingerichtet ist, das zweite Stellantriebssignal und das Wechselstromsignal asynchron in das Stellantriebselement (62) einzuspeisen, und wobei optional die Stromeinspeisungseinrichtung (70) dafür eingerichtet ist, mit der Einspeisung des Wechselstromsignals vor der Einspeisung des zweiten Stellantriebssignals zu beginnen.

12. Stellantriebsvorrichtung nach einem der vorangehenden Ansprüche, wobei die Vorrichtung einen Speicher oder eine Nachschlagetabelle zum Speichern des ersten und des zweiten Grades der Verformung des Stellantriebselements (62) als Reaktion auf das erste und das zweite Stellantriebssignal und zum Speichern des Wechselstromsignals umfasst.

13. Stellantriebsverfahren für eine Stellantriebsvorrichtung, die umfasst: ein Stellantriebselement (62), das ein elektroaktives Material (64) umfasst, das dahingehend verformbar ist, dass es seine Größe und/oder Form als Reaktion auf ein elektrisches Signal ändert, wobei das Stellantriebselement (62) so eingerichtet ist, dass es als Reaktion darauf, dass das elektrische Signal ein erstes Stellantriebssignal ist, einen ersten Grad an Verformung, als Reaktion darauf, dass das elektrische Signal ein zweites Stellantriebssignal ist, einen zweiten Grad an Verformung und als Reaktion darauf, dass das elektrische Signal ein Wechselstromsignal enthält, eine einseitig gerichtete Verringerung von dem zweiten Grad an Verformung auf den ersten Grad an Verformung zeigt; eine Stromeinspeisungseinrichtung (70) zum Einspeisen des elektrischen Signals in das Stellantriebselement (62); und eine Steuerung (72) zum Steuern der Stromeinspeisungseinrichtung (70),
wobei das Verfahren umfasst:
Bewirken, dass die Stromeinspeisungseinrichtung (70) das zweite Stellantriebssignal, das zumindest zum Teil mit dem Wechselstromsignal überlagert ist, in das Stellantriebselement (62) einspeist, um dadurch den ersten Grad an Verformung zu erreichen, wobei die Steuerung das Stellantriebselement (62) so steuert, dass es sich durch Einspeisen des zweiten Stellantriebssignals, das dafür geeignet ist, das Stellantriebselement (62) so einzurichten, dass es den zweiten Grad an Verformung zeigt, der höher ist als der erste Grad an Verformung, und Einspeisen des Wechselstromsignals, um bei dem ersten Grad an Verformung anzukommen, auf den ersten Grad an Verformung verformt.

14. Stellantriebsverfahren nach Anspruch 13, ferner eine Abschwächung des eingespeisten zweiten Stellantriebssignals und des Wechselstromsignals nach deren Anlegung umfassend, um das Stellantriebselement (62) bei dem ersten Grad an Verformung zu halten.

15. Stellantriebsverfahren nach Anspruch 14, wobei die Abschwächung eine Verringerung des zweiten Stellantriebssignals auf den Pegel, der nötig ist, um den ersten Grad an Verstellung zu erreichen, und das Verringern des Wechselstromsignalpegels auf null umfasst.

16. Computerprogrammprodukt, das einen computerlesbaren Code umfasst, der auf einem computerlesbaren Medium gespeichert oder speicherbar ist oder aus einem Netz herunterladbar ist, wobei der Code, wenn er von einer Steuerung ausgeführt wird, die Steuerung veranlasst, die Schritte des Verfahrens nach einem der Ansprüche 13 bis 15 durchzuführen.

## Revendications

1. Dispositif actionneur, comprenant :
un élément actionneur (62) comprenant une matière électroactive (64), laquelle est déformable de telle sorte qu'elle change de taille et/ou de forme en réponse à un signal électrique, l'élément actionneur (62) étant conçu pour présenter un premier niveau de déformation en réponse au signal électrique étant un premier signal d'actionnement, un second niveau de déformation, lequel est supérieur au premier niveau de déformation, en réponse au signal électrique étant un second signal d'actionnement, et une réduction unidirectionnelle du second niveau de déformation au premier niveau de déformation en réponse au signal électrique comprenant un signal CA ;
un moyen d'alimentation électrique (70) destiné à la fourniture du signal électrique à l'élément d'actionnement (62) ; et
un dispositif de commande (72) destiné à la commande du moyen d'alimentation électrique (70) ;
dans lequel le dispositif de commande (72) est conçu pour amener le moyen d'alimentation électrique (70) à fournir à l'élément d'actionnement (62) le signal électrique étant le second signal d'actionnement au moins partiellement superposé au signal alternatif pour ainsi atteindre le premier niveau de déformation, le dispositif de commande étant conçu pour commander l'élément actionneur (62) de manière qu'il se déforme jusqu'au premier niveau de déformation par fourniture du second signal d'actionnement approprié pour agencer l'élément actionneur (62) pour présenter le second niveau de déformation, lequel est supérieur au premier niveau de déformation, et pour fournir le signal alternatif pour attendre le premier niveau de déformation.

2. Dispositif actionneur selon la revendication 1, dans lequel le signal alternatif est un signal de chauffage destiné à l'induction du chauffage de l'élément d'actionnement (62).

3. Dispositif actionneur selon la revendication 1 ou 2, dans lequel le dispositif de commande (72) est en outre conçu pour diminuer le second signal d'actionnement fourni et le signal alternatif après leur application de manière à maintenir l'élément d'actionnement (62) audit niveau de déformation donné.

4. Dispositif actionneur selon la revendication 3, dans lequel le dispositif de commande (72) est en outre conçu pour déterminer le taux de diminution de l'un ou des deux du second signal d'actionnement et du signal CA en fonction d'une augmentation connue du niveau d'actionnement en fonction du temps pour le second signal d'actionnement initialement fourni.

5. Dispositif actionneur selon la revendication 3 ou 4, dans lequel le dispositif de commande (72) est en outre conçu pour réduire le second signal d'actionnement au niveau requis pour atteindre le premier niveau d'actionnement, et pour réduire le niveau de signal alternatif à zéro.

6. Dispositif actionneur selon l'une quelconque des revendications 3 à 5, dans lequel le dispositif de commande (72) est en outre conçu pour réaliser la diminution du second signal d'actionnement et du signal alternatif après un délai donné ou lors de la détermination que ledit premier niveau de déformation a été atteint.

7. Dispositif actionneur selon l'une quelconque des revendications 3 à 6, dans lequel le dispositif de commande (72) est en outre conçu pour réaliser la diminution du second signal d'actionnement et du signal alternatif de manière synchrone et à un taux correspondant.

8. Dispositif actionneur selon l'une quelconque des revendications précédentes, dans lequel l'élément d'actionnement (62) est conçu pour présenter une variation connue du niveau de déformation en fonction du niveau du signal d'actionnement, et dans lequel l'élément actionneur (62) est conçu pour présenter une réduction connue du niveau de déformation en fonction du niveau de signal alternatif.

9. Dispositif actionneur selon l'une quelconque des revendications précédentes, dans lequel le dispositif de commande (72) est conçu pour fournir au second signal d'actionnement un niveau non supérieur que 12% supérieur au premier niveau de signal d'actionnement, et de préférence avec un niveau compris entre 8% et 12% supérieur au premier niveau de signal.

10. Dispositif actionneur selon l'une quelconque des revendications précédentes, dans lequel le moyen d'alimentation électrique (70) est conçu pour fournir le second signal d'actionnement et le signal alternatif à l'élément d'actionnement (62) de manière synchrone.

11. Dispositif actionneur selon l'une quelconque des revendications précédentes, dans lequel le moyen d'alimentation électrique (70) est conçu pour fournir le second signal d'actionnement et le signal alternatif à l'élément d'actionnement (62) de manière asynchrone, et éventuellement dans lequel le moyen d'alimentation électrique (70) est conçu pour commencer à fournir le signal alternatif avant la fourniture du second signal d'actionnement.

12. Dispositif actionneur selon l'une quelconque des revendications précédentes, dans lequel le dispositif comprend une mémoire ou une table de recherche destinée à la mémorisation des premier et second niveaux de déformation de l'élément d'actionnement (62) en réponse aux premier et second signaux d'actionnement et à la mémorisation du signal alternatif.

13. Procédé d'actionnement pour un dispositif actionneur, lequel comprend un élément d'actionnement (62) comprenant une matière électroactive (64), laquelle est déformable de telle sorte qu'elle change de taille et/ou de forme en réponse à un signal électrique, l'élément actionneur (62) étant conçu pour présenter un premier niveau de déformation en réponse au signal électrique étant un premier signal d'actionnement, un second niveau de déformation, lequel est supérieur au premier niveau de déformation en réponse au signal électrique étant un second un signal d'actionnement, et une réduction unidirectionnelle du second niveau de déformation au premier niveau de déformation en réponse au signal électrique comprenant un signal alternatif ; un moyen d'alimentation électrique (70) destiné à la fourniture du signal électrique à l'élément d'actionnement (62) ; et un dispositif de commande (72) destiné à la commande du moyen d'alimentation électrique (70), dans lequel le procédé comprend :
l'amenée du moyen d'alimentation électrique (70) à fournir à l'élément d'actionnement (62) le second signal d'actionnement superposé au moins partialement au signal alternatif pour ainsi atteindre le premier niveau de déformation, le dispositif de commande commandant l'élément actionneur (62) de manière qu'il se déforme jusqu'au premier niveau de déformation par fourniture du second signal d'actionnement approprié pour agencer l'élément actionneur (62) pour présenter le second niveau de déformation, lequel est supérieur au premier niveau de déformation, et pour fournir le signal alternatif pour attendre le premier niveau de déformation.

14. Procédé d'actionnement selon la revendication 13, comprenant en outre la diminution du second signal d'actionnement et du signal alternatif fournis après leur application de manière à maintenir l'élément d'actionnement (62) au premier niveau de déformation.

15. Procédé d'actionnement selon la revendication 14, la diminution comprenant la réduction du second signal d'actionnement au niveau requis pour atteindre le premier niveau d'actionnement, et la réduction du niveau de signal alternatif à zéro.

16. Produit de programme informatique comprenant un code lisible par ordinateur mémorisé sur ou pouvant être mémorisé sur un support lisible par ordinateur, ou téléchargeable à partir d'un réseau, ledit code, lorsqu'il est exécuté par un dispositif de commande, amenant le dispositif de commande à mettre en œuvre les étapes du procédé selon l'une quelconque des revendications 13 à 15.
